# EUROPEAN PATENT APPLICATION

(11) **EP 4 797 327 A1**
(43) Date of publication of application: **26.08.2026**
(21) Application number: 25158708.5
(22) Date of filing: 19.02.2025
(51) Int. Cl.: H01L 23/367, H01L 23/427, H01L 23/44, H01L 23/473, H01L 21/683, H01L 25/00

(54) **SEMICONDUCTOR CHIPS COMPRISING COOLING CHANNELS**

(71) Applicant: Nokia Solutions and Networks Oy, 02610 Espoo (FI)
(72) Inventor: LIU, Yang, Short Hills, NJ (US); FAISAL, Syed, Newark, NJ (US); ROY, Rishav, Somerset, NJ (US); PARBAT, Sarwesh, Summit, NJ (US); BONGARALA, Manohar, Springfield, NJ (US); APIGO, David, Mountainside, NJ (US); SALAMON, Todd, New Providence, NJ (US); EARNSHAW, Mark, Berkeley Heights, NJ (US)
(74) Representative: Swindell & Pearson Limited

(57) **Abstract**

Examples of the disclosure relate to semiconductor chips and methods of forming semiconductor chips. The chips comprise multiple integrated circuit layers arranged in a stack and a cooling channel positioned between integrated circuit layers. The cooling channel is bounded by at least two walls and configured to enable a cooling fluid to provide cooling of electronic and/or photonic components on the integrated circuit layers. The walls comprise a first bonding material arranged on a first edge of the walls, for bonding the first edges of the walls to the first integrated circuit layer. The walls also comprise a second bonding material arranged on a second edge of the walls, for bonding the second edges of the walls to the second integrated circuit layer.

## Description

### TECHNOLOGICAL FIELD

Examples of the disclosure relate to semiconductor chips and methods of forming semiconductor chips comprising cooling channels.

### BACKGROUND

Semiconductor chips (referred to as chips herein) comprise circuitry such as electronic and/or photonic components that can generate unwanted heat during use. It is useful for the chips to comprise cooling channels to enable cooling of the electronic and/or photonic components within the chips.

### BRIEF SUMMARY

According to various, but not necessarily all, examples of the disclosure there may be provided a chip comprising:
multiple integrated circuit layers wherein each respective integrated circuit layer comprises one or more electronic and/or photonic components and the multiple integrated circuit layers are arranged in a stack;
a cooling channel positioned between a first integrated circuit layer and a second integrated circuit layer of the multiple integrated circuit layers wherein the cooling channel is bounded by at least a first wall and a second wall and configured to enable a cooling fluid to provide cooling of one or more electronic and/or photonic components on the multiple integrated circuit layers; and
wherein the first wall and the second wall comprise:
   a first bonding material arranged on a first edge of the first wall and the second wall, respectively, for bonding the first edge of the first wall and the first edge of the second wall to the first integrated circuit layer; and
   a second bonding material arranged on a second edge of the first wall and the second wall, respectively, for bonding the second edge of the first wall and the second edge of the second wall to the second integrated circuit layer.

The first bonding material and the second bonding material may have different melting points.

The first wall and the second wall may provide structural support for at least one of the first integrated circuit layer or the second integrated circuit layer.

The first wall and the second wall may provide side edges for the cooling channel, and wherein the first integrated circuit layer and the second integrated circuit layer may provide upper and lower edges for the cooling channel.

At at least one of the first wall and the second wall may provide a barrier between two adjacent cooling channels.

The first wall and the second wall may comprise an electrically conductive material.

The first wall and/or the second wall may be configured to enable power and/or electrical signals to be transferred between the first integrated circuit layer and the second integrated circuit layer.

The chip may further comprise a heat sink.

The heat sink may comprise a surface and the surface may provide a substrate for at least one of the first integrated circuit layer or the second integrated circuit layer.

At least one of the first and the second integrated circuit layer may comprise one or more through-silicon vias (TSVs).

Each of the first wall and the second wall may comprise a first horizontal portion and a second horizontal portion, wherein the first portion and the second portion may be bonded to each other by a third bonding material.

The cooling channel may be a microfluidic channel.

The cooling channel may be a closed channel.

The channel may be an open channel.

The chip may further comprise a hydrophilic film positioned within the cooling channel.

The chip may further comprise a hydrophobic film positioned within the cooling channel.

According to various, but not necessarily all, examples of the disclosure there may be provided a method of forming a chip, the method comprising:
forming at least two walls, including a first wall and a second wall, on a carrier layer, wherein the walls are arranged to provide a cooling channel between the first wall and the second wall;
attaching a first edge of the first wall and a first edge of the second wall to a first integrated circuit layer;
removing the first wall and the second wall from the carrier layer; and
attaching a second edge of the first wall and a second edge of the second wall to a second integrated circuit layer so that the first integrated circuit layer and the second integrated circuit layer are arranged in a stack and the cooling channel is positioned between the first integrated circuit layer and the second integrated circuit layer.

Forming the first wall and the second wall may comprise:
forming pits in the carrier layer;
depositing first bonding material in the pits;
depositing material over the first bonding material to form the first wall and the second wall; and
depositing second bonding material on exposed upper edges of the first wall and the second wall.

Forming the first wall and the second wall may comprise:
providing a releasable layer on the carrier layer;
depositing first bonding material on the releasable layer;
depositing material over the first bonding material to form the first wall and the second wall; and
depositing second bonding material on exposed edges of the first wall and the second wall.

The method may also comprise:
attaching a first portion of the first wall and a first portion of the second wall to the first integrated circuit layer;
providing a second portion of the first wall and a second portion of the second wall on a carrier layer;
bonding the first portion of the first wall to the second portion of the first wall and bonding the first portion of the second wall to the second portion of the second wall;
removing the carrier layer from the second portion of the first wall and from the second portion of the second wall; and
bonding the second portion of the first wall and the second portion of the second wall to a second integrated circuit layer.

The method may also comprise providing a heat sink thermally coupled to the cooling channel.

At least one of the first and second integrated circuit layers may comprise a portion of the heat sink.

According to various, but not necessarily all, embodiments there is provided an apparatus comprising:
at least one processor; and
at least one memory;
the at least one memory storing instructions that, when executed by the at least one processor, cause the apparatus to perform at least a part of one or more methods described herein.

According to various, but not necessarily all, embodiments there is provided an apparatus comprising means for performing at least part of one or more methods described herein. The description of a function and/or action should additionally be considered to also disclose any means suitable for performing that function and/or action. Functions and/or actions described herein can be performed in any suitable way using any suitable method.

According to various, but not necessarily all, embodiments there is provided examples as claimed in the appended claims.

While the above examples of the disclosure and optional features are described separately, it is to be understood that their provision in all possible combinations and permutations is contained within the disclosure. It is to be understood that various examples of the disclosure can comprise any or all the features described in respect of other examples of the disclosure, and vice versa. Also, it is to be appreciated that any one or more or all the features, in any combination, may be implemented by/comprised in/performable by an apparatus, a method, and/or instructions as desired, and as appropriate. The description of a function should additionally be considered to also disclose any means suitable for performing that function

### BRIEF DESCRIPTION

Some examples will now be described with reference to the accompanying drawings in which:
FIG. 1 shows a chip;
FIG. 2 shows a method;
FIGS. 3A to 3C show a method;
FIGS. 4A to 4C show a method;
FIGS. 5A to 5D show a method;
FIGS. 6A and 6B show cooling channels;
FIG. 7 shows a chip;
FIG. 8 shows a chip;
FIG. 9 shows a chip;
FIG. 10 shows a chip;
FIG. 11 shows a chip;
FIG. 12 shows a chip; and
FIG. 13 shows a chip.

The figures are not necessarily to scale. Certain features and views of the figures can be shown schematically or exaggerated in scale in the interest of clarity and conciseness. For example, the dimensions of some elements in the figures can be exaggerated relative to other elements to aid explication. Corresponding reference numerals are used in the figures to designate corresponding features. For clarity, all reference numerals are not necessarily displayed in all figures.

### DETAILED DESCRIPTION

Examples of the disclosure relate to a chip comprising one or more cooling channels and methods of forming such chips. The chip has a three-dimensional structure. For example, thechip can comprise two or more integrated circuit layers stacked on top of each other. Each of the respective integrated circuit layers can comprise one or more electronic and/or photonic components. Stacking integrated circuit layers to form a three dimensional chip requires a smaller footprint compared to providing all the components on the same layer or providing multiple integrated circuit layers side by side. However, stacking the integrated circuit layers on top of each other can result in overheating of components within the integrated circuit layers. Examples of the disclosure therefore provide a chip with cooling channels to aid cooling of the components within the integrated circuit layers. Examples of the disclosure also provide methods for forming such chips.

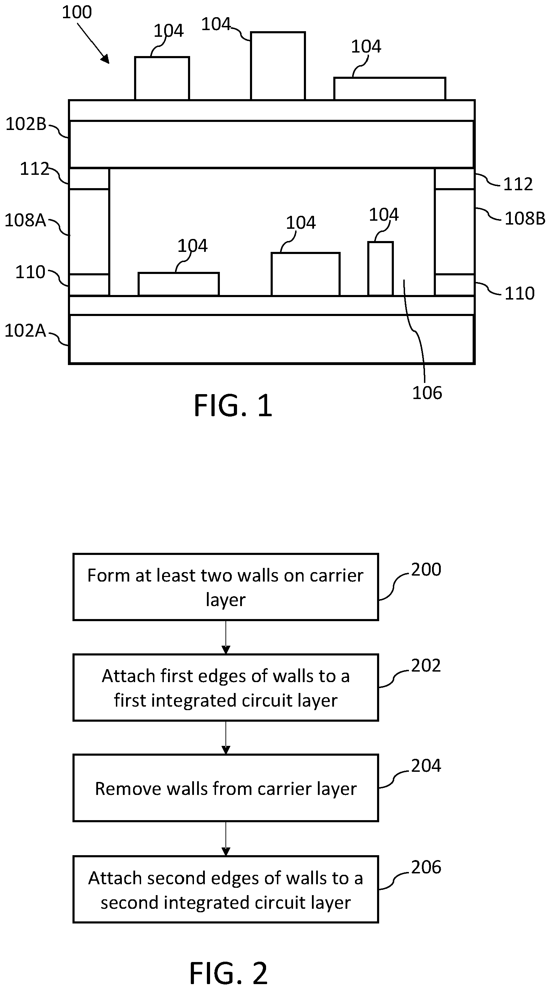

Fig. 1 schematically shows a vertical cross section through a chip 100. In the example of Fig. 1 the chip 100 comprises multiple integrated circuit layers 102A, 102B and a cooling channel 106. Only components referred to in the following description are shown in Fig. 1. The chip 100 could comprise other components in examples of the disclosure.

The chip 100 comprises multiple integrated circuit layers 102A, 102B. In the example of Fig. 1 the chip 100 comprises two integrated circuit layers 102A, 102B. The chip 100 can comprise additional integrated circuit layers (not shown) in other examples.

The integrated circuit layers 102A, 102B are arranged in a stack. The integrated circuit layers 102A, 102B are arranged in a stack so that a second integrated circuit layer 102B at least partially overlays a first integrated circuit layer 102A. In some examples the second integrated circuit layer 102B can overlay the first integrated circuit layer 102A so that it is positioned within the footprint of the first integrated circuit layer 102A. Arranging the integrated circuit layers in a stack can provide a three-dimensional chip 100. The chip 100 is three dimensional in that electronic and/or photonic components can be arranged on multiple different integrated circuit layers 102A, 102B.

Each of the respective integrated circuit layers 102A, 102B can comprise multiple internal layers located atop each other. The internal layers of each of the integrated circuit layers can include, for example, a substrate and an interconnect on top of the substrate. The substrate can comprise mainly a semiconductor material such as silicon. The substrate can comprise doped and undoped regions to provide electronic components such as transistors. The interconnect interconnects the electronic components of the substrate. The interconnect can comprise multiple patterned layers of electrically conductive material such as metal. In one embodiment, the integrated circuit layers 102A, 102B have been formed using photolithography.

One or more electronic and/or photonic components 104 are mounted on one or more of the integrated circuit layers 102A, 102B. In the shown example, one or more electronic and/or photonic components 104 are mounted on a top face of each of the integrated circuit layers 102A, 102B. The top (or bottom) face of each of the integrated circuit layers 102A, 102B can be a top (or bottom) face of a substrate of the respective integrated circuit layer. The top (or bottom) faces of the integrated circuit layers can be flat, or substantially flat, surfaces that the electronic and/or photonic components 104 can be mounted on.

Geometrical planes extending parallel to these surfaces are considered "horizontal" in this disclosure. In other words, the adjectives "horizontal" and "vertical" are defined in a spatial reference frame that is fixed to the chip 100. In this sense, the surfaces on which the electronic and/or photonic components 104 are arranged are horizontal regardless of the orientation of the chip 100 relative to Earth.

In the example of Fig. 1 the components 104 are shown as discrete components. In some examples the components 104 can be integrated. For instance the components 104 could comprise integrated circuits, photonic circuits, III-V semiconductor chips, II-VI semiconductor-chips, MEMS (Micro-electromechanical system) semi-conductor chips or any suitable type of semiconductor chips. The components 104 can be integrated into a heterogeneous integrated systems using a stacking method. The components 104 can comprise active components such as transistors, photo diodes, lasers, and/or passive components such as inductors, capacitors, resistors, wave guides, wirings, or any other suitable type of components 104.

The components 104 can protrude from the surface of the integrated circuit layers 102A, 102B, be embedded in the integrated circuit layers 102A, 102B or be flush to surface of the integrated circuit layers 102A, 102B. The components 104 can comprise components such as memories, processors or any other suitable components. The components 104 can comprise high power components and/or low power components. At least some of the components 104 can generate unwanted heat during use. At least some of the components 104 can be negatively affected if they get too hot. For example, a component 104 such as a photo detector can have an ideal operational temperature range and if the temperature exceeds this the accuracy and/or efficiency of the component 104 could be reduced.

In the example of Fig. 1 three electronic and/or photonic components 104 are shown on each of the integrated circuit layers 102A, 102B. Other numbers of electronic and/or photonic components 104 can be used in other examples of the disclosure.

The chip 100 also comprises a cooling channel 106. The cooling channel 106 is positioned between the first integrated circuit layer 102A and the second integrated circuit layer 102B. The cooling channel 106 is formed by at least a first wall 108A and a second wall 108B. The cooling channel 106 is configured to enable a cooling fluid to provide cooling of one or more electronic and/or photonic components 104 on the multiple integrated circuit layers 102A, 102B.

The cooling channel 106 can be a microfluidic channel. A microfluidic channel is a channel having a height and width in a range of approximately a tenth of a micron and a few millimetres, most often between a micron and a millimetre. In a microfluidic channel 106 the cooling fluid can flow through the channel via capillary action or pressure differences.

The cooling channel 106 can be a closed channel or an open channel. In a closed channel 106 the cooling fluid can remain within the cooling channel 106. The closed channel 106 could be used in a passive cooling system such as an oscillating heat pie or any other suitable cooling system. In an open channel the cooling fluid could be pumped though the channel 106.

The cooling fluid can for example be a water-based coolant or a fluorine-based refrigerant. One example of a fluorine-based refrigerant is R1233zd(E).

In the example of Fig. 1 the first wall 108A and the second wall 108B extend between the first integrated circuit layer 102A and the second integrated circuit layer 102A so as to provide a spacing between the first integrated circuit layer 102A and the second integrated circuit layer 102A. The spacing provides the cooling channel 106. The first wall 108A and the second wall 108B provide side edges for the cooling channel 106. The integrated circuit layers 102A, 102B provide upper and lower edges for the cooling channel 106.

The first wall 108A and the second wall 108B comprise a first bonding material 110 arranged on a first edge of the walls 108A, 108B. The first bonding material 110 bonds the first edge of the first wall 108A to the first integrated circuit layer 102A. The first bonding material 110 also bonds the first edge of the second wall 108B to the first integrated circuit layer 102A.

The first wall 108A and the second wall 108B also comprise a second bonding material 112 arranged on a second edge of the walls 108A, 108B. The second bonding material 112 bonds the second edge of the first wall 108A to the second integrated circuit layer 102B. The second bonding material 112 also bonds the second edge of the second wall 108B to the second integrated circuit layer 102B.

The edges of the walls 108A, 108B can comprise the upper and lower surfaces of the walls 108A, 108B.

The bonding materials 110, 112 can comprise solder material or any other suitable type of material that enables the edges of the walls 108A, 108B to be bonded to the integrated circuit layers 102A, 102B. The first bonding material 110 and the second bonding material 112 can comprise different materials. In some examples the first bonding material and the second bonding material can have different melting points.

In some examples the first wall 108A and the second wall 108B can provide structural support for one or more of the integrated circuit layers 102A, 102B. In the example of Fig. 1 the second integrated circuit layer 102B could be supported by walls 108A, 108B. The walls 108A, 108B could, at least partially, bear the weight of the second integrated circuit layer 102B.

In some examples the first wall 108A and/or the second wall 108B could comprise an electrically conductive material. This could enable the first wall 108A and/or the second wall 108B to provide electrical connections between components 104 on the first integrated circuit layer 102A and components 104 on the second integrated circuit layer 102B. This can enable power and/or electrical signals to be transferred between the first integrated circuit layer 102A and the second integrated circuit layer 102B.

Variations to the chip 100 shown in Fig.1 can be used in implementations of the disclosure. For instance, in Fig. 1 the chip 100 comprises a single cooling channel 106. In other examples the chip 100 could comprise multiple cooling channels 106. In such cases the chip 100 could comprise more than two walls 108A, 108B so as to provide the multiple cooling channels 106. In some examples one of the walls 108A, 108B could provide a barrier between adjacent cooling channels 106.

In some examples the walls 108A, 108B can comprise multiple portions. For instance, the first wall 108A and the second wall 108B can each comprise a first horizontal portion and a second horizontal portion. The horizontal portions are portions that are located in a stacked arrangement with one horizontal portion over another horizontal portion (with the chip 100 in an orientation as shown in Fig. 1). The first horizontal portion and the second horizontal portion can be bonded to each other by a third bonding material. Having the walls 108A, 108B comprise multiple portions can enable taller walls 108A, 108B to be provided. This can provide a cooling channel 106 with a higher aspect ratio.

In some examples the chip 100 can comprise additional components that are not shown in Fig. 1. For example, the chip 100 could comprise one or more heat sinks. A heat sink could comprise any means for removing heat from the chip 100. In some examples the heat sink can comprise a surface. In some examples the surface of the heat sink can provide a substrate for at least one of the first integrated circuit layer 102A or the second integrated circuit layer 102B.

In some examples at least one of the integrated circuit layers 102A, 102B can comprise one or more through-silicon vias (TSV).

In some examples the chip 100 could comprise a hydrophilic film. The hydrophilic film can be positioned within the cooling channel 106. The hydrophilic film can be positioned near to heat sources to help with heat transfer.

In some examples the chip 100 could comprise a hydrophobic film. The hydrophobic film can be positioned within the cooling channel 106. The hydrophobic film can be positioned away from heat sources to help with fluid movement.

Fig. 2 shows an example method for forming a chip 100. The method could be used to form a chip 100 as shown in Fig. 1 or any other suitable type of chip 100.

The method comprises, at block 200, forming at least two walls 108A, 108B. The at least two walls can include a first wall 108A and a second wall 108B. The walls 108A, 108B are formed on a carrier layer. In some examples the walls 108A, 108B can be formed directly on the carrier layer so that the walls 108A, 108B are in direct contact with the surface of the carrier layer. In other examples the walls 108A, 108B can be formed indirectly on the carrier layer so that the walls 108A, 108B do not make direct contact with carrier layer. In such examples a releasable layer or other material can be provided between the walls 108A, 108B and the carrier layer.

The walls 108A, 108B can be formed by any suitable process such as electroplating, sputtering, or any other suitable process.

The walls 108A, 108B are arranged to provide a cooling channel 106 between the first wall 108A and the second wall 108B. The spacing and/or shaping of the walls 108A, 108B relative to each other provide a cooling channel 106. The walls 108A, 108B provide side edges for the cooling channel 106.

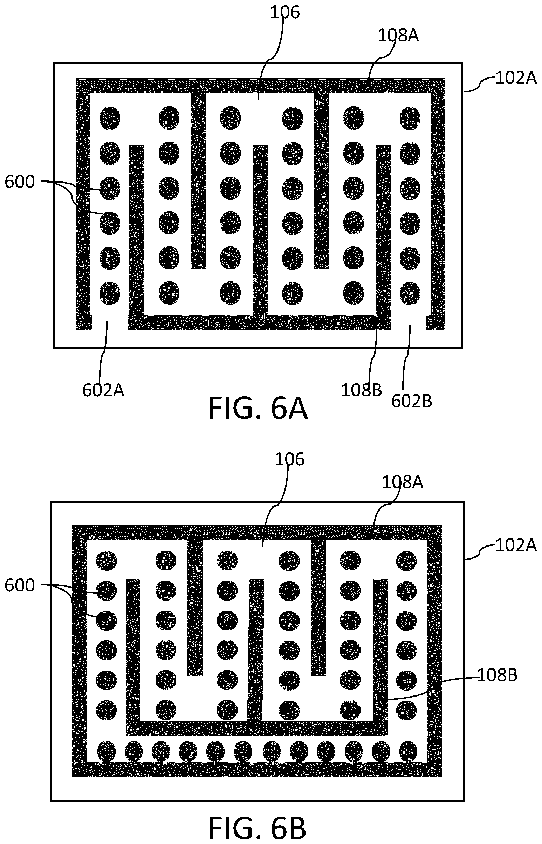

The walls 108A, 108B can be formed from any suitable material. In some examples the material used to form the walls 108A, 108B is electrically conductive. This will allow transmitting an electrical signal or electrical power through the walls 108A, 108B. Pillars 600 can be formed with the same process and materials as the walls 108A, 108B. Pillars can help to increase mechanical strength, conduct electrical signal or electrical power, and to help remove heat as pin fins. Some examples pillars 600 are shown in Figs. 6A and 6B.

At block 202 the method comprises attaching a first edge of the first wall 108A and a first edge of the second wall 108B to a first integrated circuit layer 102A. The first integrated circuit layer 102A comprises a substrate. The first edges of the walls 108A, 108B are attached to the substrate of the first integrated circuit layer 102A. The first edges of the walls 108A, 108B are the edges that are not attached to the carrier layer.

A first bonding material 110 can be used to attach the first edges of the walls 108A, 108B to the first integrated circuit layer 102A.

At block 204 the first wall 108A and the second wall 108B are removed from the carrier layer.

At block 206 the method comprises attaching a second edge of the first wall 108A and a second edge of the second wall 108B to a second integrated circuit layer 102B. The second edges of the walls 108A, 108B are attached to the second integrated circuit layer 102B so that the first integrated circuit layer 102A and the second integrated circuit layer 102B are arranged in a stack and the cooling channel 106 formed by the walls 108A, 108B is positioned between the first integrated circuit layer 102A and the second integrated circuit layer 102B.

A second bonding material 112 can be used to attach the second edges of the walls 108A, 108B to the second integrated circuit layer 102B.

Different processes can be used to form the walls 108A, 108B in different examples of the disclosure.

In some examples the walls 108A, 108B could be formed by forming pits in the carrier layer and then depositing first bonding material 110 in the pits. The first bonding material 110 could be a solder material or any other suitable material. Material can then be deposited over the first bonding material 110 to form the first wall 108A and the second wall 108B. Once the first wall 108A and the second wall 108B have been formed a second bonding material can be deposited on exposed upper edges of the first wall 108A and the second wall 108B. The second bonding material 112 can also be a solder material or any other suitable type of material.

In other examples the walls 108A, 108B could be formed by providing a releasable layer on the carrier layer and depositing first bonding material 110 on the releasable layer. The first wall 108A and the second wall 108B can then be formed by depositing material over the first bonding material 110. Once the first wall 108A and the second wall 108B have been formed a second bonding material can be deposited on exposed upper edges of the first wall 108A and the second wall 108B. The second bonding material 112 can also be a solder material or any other suitable type of material.

In some examples the method could comprise additional blocks that are not shown in Fig. 2. For example, the walls 108A, 108B can comprise multiple portions and the method can comprise blocks that enable the respective portions to be formed and the attached to each other. In such examples the method can comprise attaching a first portion of the first wall 108A and a first portion of the second wall 108B to the first integrated circuit layer 102A. The method also comprises providing a second portion of the first wall 108A and a second portion of the second wall 108B on a carrier layer and bonding the first portion of the first wall 108A to the second portion of the first wall 108A and bonding the first portion of the second wall 108B to the second portion of the second wall 108B. Once the respective portions have been bonded together the carrier layer can be removed from the second portion of the first wall 108A and from the second portion of the second wall 108B. The second portion of the first wall 108A and the second portion of the second wall 108B to a second integrated circuit layer 102B.

In some examples the chip 100 could comprise components such as a heat sink. In some examples one or more of the integrated circuit layers 102A, 102B can comprise a portion of the heat sink. The method can comprise providing the heat sink and thermally coupling the heat sink to the cooling channel 106.

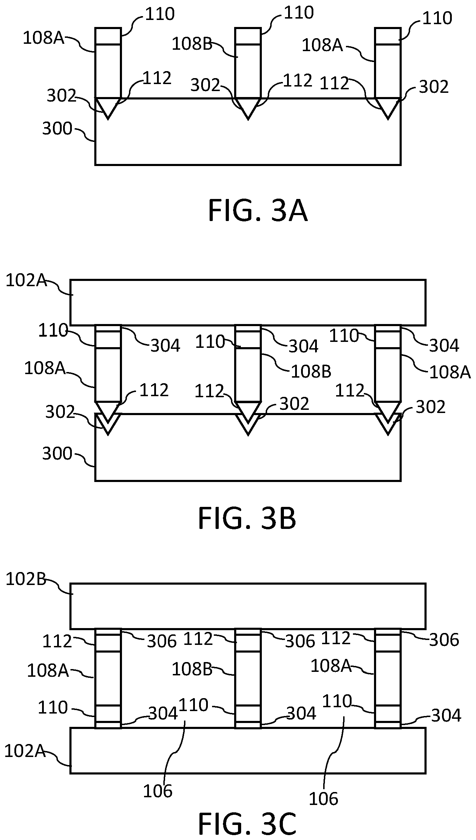

Figs. 3A to 3C show a first example method of forming walls 108A, 108B for a cooling channel 106. In this example the walls 108A, 108B can be formed using controlled low adhesion methods.

In Fig. 3A pits 302 are formed in a carrier layer 300. The carrier layer 300 can comprise silicon or any other suitable material.

Fig. 3A shows a cross section of the carrier layer 300. The pits 302 in this example have a triangular cross section. Other shapes for the pits 302 could be used in other example such as cylindrical cross sections, curved cross sections or any other suitable shape. The pits 302 can extend across the surface of the carrier layer 300 so as to provide a trace upon which the walls 108A, 108B can be formed.

The pits 302 can be formed in the surface of the carrier layer 300 using pattern and etching or any other suitable process.

A bonding material 112 can be deposited in the pits 302. The bonding material 112 could be formed from a solder material. The bonding material 112 within the pits 302 can provide a non-planar surface that causes local current crowding within the pits 302 and helps nucleation in the pit 302 for the formation of the walls 108A, 108B.

The walls 108A, 108B can then be formed over the bonding material 112 by electroplating or any other suitable process. The walls 108A, 108B can be formed from an electrically conductive material such as copper or any other suitable material.

The walls 108A, 108B have an elongate cross section and extend out of the surface of the carrier layer 300. The walls 108A, 108B comprise a first edge and a second edge. In this example the first edge of the wall 108A, 108B is the edge of the wall 108A, 108B that is not in contact with the pit 302. The second edge of the wall 108A, 108B is the edge that is on contact with the pit 302. The walls 108A, 108B also comprise lateral surfaces between the edges.

A bonding material 110 is also provided on a first edge of the wall 108A, 108B. The bonding material 110 can comprise solder material or any other suitable material.

In the example of Fig. 3A three sections of the walls 108A, 108B are shown. In this example they are sections of two different walls 108A, 108B. In other examples they could be sections of the same wall. For example, a wall could follow a meandering path over the surface of the carrier layer 300.

In Fig. 3B the first edges of the walls 108A, 108B are attached to a first integrated circuit layer 102A. The bonding material 110 can be used to attach the first edges of the walls 108A, 108B to the first integrated circuit layer 102A. The bonding material 110 can be attached to a bonding pad 304 of the first integrated circuit layer 102A.

The first integrated circuit layer 102A can comprise one or more electronic or photonic components. These are not shown in Figs. 3A to 3C.

In Fig. 3C the second edge of the walls 108A, 108B is attached to a second integrated circuit layer 102B. The bonding material 112 can be used to attach the second edge of the walls 108A, 108B to the second integrated circuit layer 102B. The second edge of the walls 108A, 108B are at an opposing end of the walls 108A, 108B to the first edge. The bonding material 112 can be attached to a bonding pad 306 of the second integrated circuit layer 102B.

The second integrated circuit layer 102B can also comprise one or more electronic or photonic components. These are not shown in Figs. 3A to 3C.

Once the second integrated circuit layer 102B is attached to second edge of the walls 108A, 108B a cooling channel 106 is formed between the integrated circuit layers 102A, 102B. The surfaces of the walls 108A, 108B provide the sides of the cooling channel 106 and the integrated circuit layers 102A, 102B provide the top edge and lower edge or the channel.

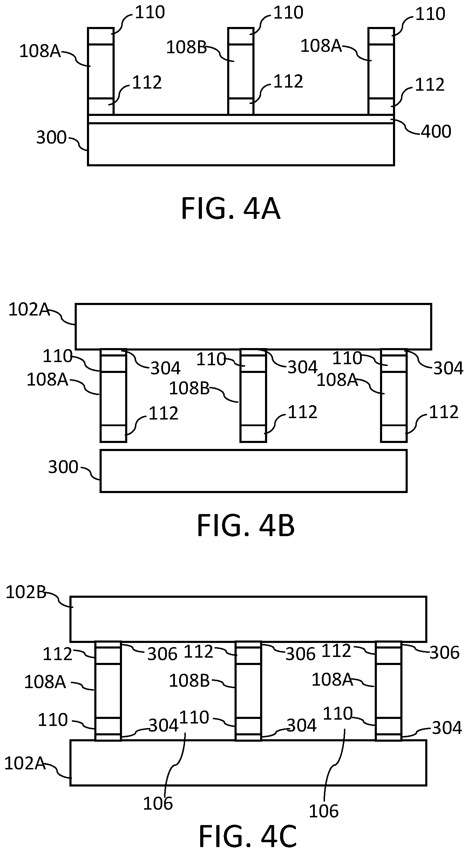

In this case the bonding material 110 provides first bonding material 110 arranged on a first edge of the walls 108A, 108B for bonding the first edge of the walls 108A, 108B to the first integrated circuit layer 102A. The bonding material 112 provides second bonding material 112 arranged on a second edge of the walls 108A, 108B for bonding the second edge of the walls 108A, 108B to the second integrated circuit layer 102B. The first bonding material 110 and the second bonding material 112 can have different melting points so that, during formation of the chip, The release of carrier layer 300 is performed at a temperature lower than the melting points of both the first bonding material 110 and the second bonding material 112. The release of carrier layer 300 can be performed at room temperature by mechanical pulling (for example, in the method of Figs. 3A to 3C). The release of carrier layer 300 can be performed at room temperature by laser ablation or low temperature sliding in (for example, in the method of Figs. 4A to 4C.)

Figs. 4A to 4C show another example method of forming walls 108A, 108B for a cooling channel 106. In this example the walls 108A, 108B can be formed on a releasable layer 400

In Fig. 4A a releasable layer 400 is formed on the surface of the carrier layer 300. The carrier layer 300 can comprise silicon or any other suitable material. Fig. 4A shows a cross section of the carrier layer 300 and the releasable layer 400.

A bonding material 112 is deposited on the releasable layer 400. The bonding material 112 could be formed from a solder material. The bonding material can provide second bonding material 112 once the chip has been formed.

The walls 108A, 108B can then be formed over the bonding material 112 by electroplating or any other suitable process. The walls 108A, 108B can be formed from an electrically conductive material such as copper or any other suitable material. The walls 108A, 108B have an elongate cross section and extend out of the surface of the releasable layer 400.

A bonding material 110 is also provided on a first edge of the wall 108A, 108B. The bonding material 110 can comprise solder material or any other suitable material. The bonding material 110 can provide first bonding material 110 once the chip has been formed. The first edge of the wall 108A, 108B is the edge of the wall that is not in contact with the releasable layer 400.

In the example of Fig. 4A three sections of the walls 108A, 108B are shown. In this example they are sections of two different walls 108A, 108B. In other examples they could be sections of the same wall. For example, a wall could follow a meandering path over the surface of the carrier layer 300.

In Fig. 4B the first edge of the walls 108A, 108B is attached to a first integrated circuit layer 102A. The bonding material 110 can be used to attach the first edge of the walls 108A, 108B to the first integrated circuit layer 102A. The bonding material 110 can be attached to a bonding pad 304 of the first integrated circuit layer 102A.

The first integrated circuit layer 102A can comprise one or more electronic or photonic components. These are not shown in Figs. 4A to 4C.

The releasable layer 400 can then be removed from the carrier layer 300 to release the walls 108A, 108B from the carrier layer 300. The releasable layer 400 can then be removed by chemicals, solvents, lasers or any other suitable means.

In Fig. 4C the second edges of the walls 108A, 108B are attached to a second integrated circuit layer 102B. The bonding material 112 can be used to attach the second edges of the walls 108A, 108B to the second integrated circuit layer 102B. The second edges of the walls 108A, 108B are at an opposing end of the walls 108A, 108B to the first edges. The bonding material 111 can be attached to a bonding pad 306 of the second integrated circuit layer 102B.

The second integrated circuit layer 102B can also comprise one or more electronic or photonic components. These are not shown in Figs. 4A to 4C.

Once the second integrated circuit layer 102B is attached to second edges of the walls 108A, 108B a cooling channel 106 is formed between the integrated circuit layers 102A, 102B. The walls 108A, 108B provide the sides of the cooling channel 106 and the integrated circuit layers 102 provide the top edge and lower edge or the channel.

The cooling channel 106 that is formed in Fig. 4C can be the same as the cooling channel 106 shown in Fig. 3C. That is, different ways of forming the cooling channel 106 can be used in different examples.

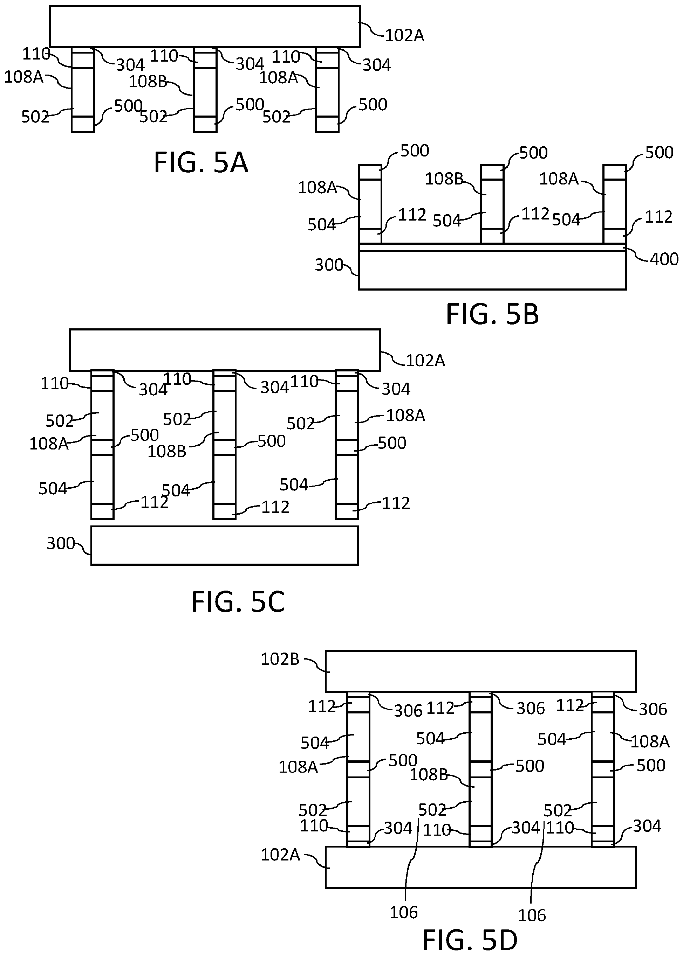

Figs. 5A to 5D show another example method of forming walls 108A, 108B for a cooling channel 106. In this example the walls 108A, 108B are formed of multiple portions. This can increase the height of the walls 108A, 108B, compared to walls 108A, 108B comprising a single portion, and can provide a cooling channel 106 with a higher aspect ratio.

In Fig. 5A a first horizontal portion 502 of walls are attached to a first integrated circuit layer 102A. In this example the first horizontal portion 502 of the walls 108A, 108B have been formed using the method as shown in Figs. 4A and 4B. The first horizontal portion 502 of the walls 108A, 108B can have the same height as the walls 108A, 108B that are formed in Figs. 4A to 4C. Other methods for forming the first horizontal portion 502 of the walls 108A, 108B could be used in other examples. For instance, the method shown in Figs. 3A to 3C could be used.

A bonding material 500 is also provided on a first edge of the first horizontal portion 502 of the walls 108A, 108B. The bonding material 500 can comprise solder material or any other suitable material. The first edge of the first horizontal portion 502 of the walls 108A, 108B is the edge of the wall that is not in contact with the first integrated circuit layer 102A.

The bonding material 500 provides a third bonding material 500 once the chip is formed. The third bonding material 500 bonds portions of a wall together. The portions can be horizontal portions.

In Fig. 5B second horizontal portions 504 of the walls 108A, 108B are formed on a releasable layer 400. The releasable layer 400 can be provided on a carrier layer 300. The second horizontal portion 504 of the walls 108A, 108B have been formed using the method as shown in Fig. 4A. Other methods can be used in other examples. The second horizontal 504 portion of the walls 108A, 108B can have the same height as the walls 108A, 108B that are formed in Figs. 4A to 4C. The second horizontal 504 portion of the walls 108A, 108B can have the same height as the first horizontal portion 502 of the walls 108A, 108B.

A bonding material 500 is also provided on a first edge of the second horizontal portion 504 of the walls 108A, 108B. The bonding material 500 can comprise solder material or any other suitable material. The bonding material 500 can be the same material that is used on the first edges of the first horizontal portions 502 of the walls 108A, 108B. The first edges of the second horizontal portions 504 of the wall 108A, 108B are the edges of the walls 108A, 108B that is not in contact with the releasable layer 400.

In Fig. 5C the first horizontal portions 502 of the walls 108A, 108B and the second horizontal portions 504 of the walls 108A, 108B are bonded together. The bonding material 500 that is provided on the respective horizontal portions 502, 504 is used to bond the portions together.

Once the first horizontal portions 502 of the walls 108A, 108B and the second horizontal portions 504 of the walls 108A, 108B are bonded together the releasable layer 400 can be removed. The releasable layer 400 can be removed by chemicals, solvents, lasers or any other suitable means.

In Fig. 5D the free edges of the walls 108A, 108B, that have been released from the releasable layer 400, are then attached to a second integrated circuit layer 102B. The bonding material 112 can be used to attach the free edges of the walls 108A, 108B to the second integrated circuit layer 102B.

The walls 108A, 108B formed using this method have a first horizontal portion 502 and a second horizontal portion 504. Once the walls 108A, 108B are formed the horizontal portions are portions that are located in a stack. In this case the second horizontal portion 504 is located over the first horizontal portion 502. The walls 108A, 108B comprising multiple portions 502, 504 have a higher aspect ratio than the walls 108A, 108B shown in Figs. 3A to 4C. The walls 108A, 108B comprising multiple portions 502, 504 can provide a cooling channel 106 with a higher aspect ratio. This can provide a larger spacing between the first integrated circuit layer 102A and the second integrated circuit layer 102B.

Figs. 6A and 6B show plan views of example cooling channels 106 on a first integrated circuit layer 102A. The same cooling channel 106 would also be provided on a second integrated circuit layer 102B because the walls 108A, 108B that form the cooling channel 106 are bonded to both the first integrated circuit layer 102A and the second integrated circuit layer 102B.

In the example of Fig. 6A the cooling channel 106 is formed from a first wall 108A and a second wall 108B. The walls 108A are shaped so that the cooling channel 106 has a meandering path over the surface of the first integrated circuit layer 102A.

In the example of Fig. 6A the cooling channel 106 is an open channel. In this case there is a first gap 602A between the first wall 108A and the second wall 108B and also a second gap 602B between the first wall 108A and the second wall 108B. The first gap 602A is provided at one side of the first integrated circuit layer 102A and the second gap 602B is provided at the other side of the first integrated circuit layer 102A.

The open cooling channel 106 can enable cooling fluid to be pumped through the cooling channel and remove heat from the integrated circuit layer.

In the example of Fig. 6B the cooling channel 106 is also formed from a first wall 108A and a second wall 108B. In this example the walls 108A are also shaped so that the cooling channel 106 has a meandering path over the surface of the first integrated circuit layer 102A.

However, in the example of Fig. 6B the cooling channel 106 is a closed channel. In this case the first wall 108A forms an enclosed region on the surface of the first integrated circuit layer 102A. There are no gaps in the first wall 108A. The second wall 108B is provided within the enclosed region.

The closed cooling channel 106 can be used for a passive cooling system such as an oscillating heat pipe.

In both Figs. 6A and 6B multiple pillars 600 are provided discontinuously in the interior of the cooling channel 106. The pillars 600 are discontinuous so that they can be electrically insulated from each other. The pillars 600 can be formed using a corresponding method to the method that is used to form the walls 108A, 108B.

In some examples such as those shown in Figs. 6A and 6B the walls 108A, 108B can be electrically conductive so that the walls 108A, 108B can be used to provide electrical signals, power signals, or ground components on the respective integrated circuit layers 102A, 102B, or can be configured for any other suitable purpose.

In the example of Figs. 6A and 6B a single cooling channel 106 is provided by two walls 108A, 108B. In other examples multiple cooling channels 106 could be provided. More than two walls can be used to provide the multiple cooling channels. For example, a third wall (not shown) could be used. In such examples a wall could be arranged to provide a barrier between two adjacent cooling channels 106.

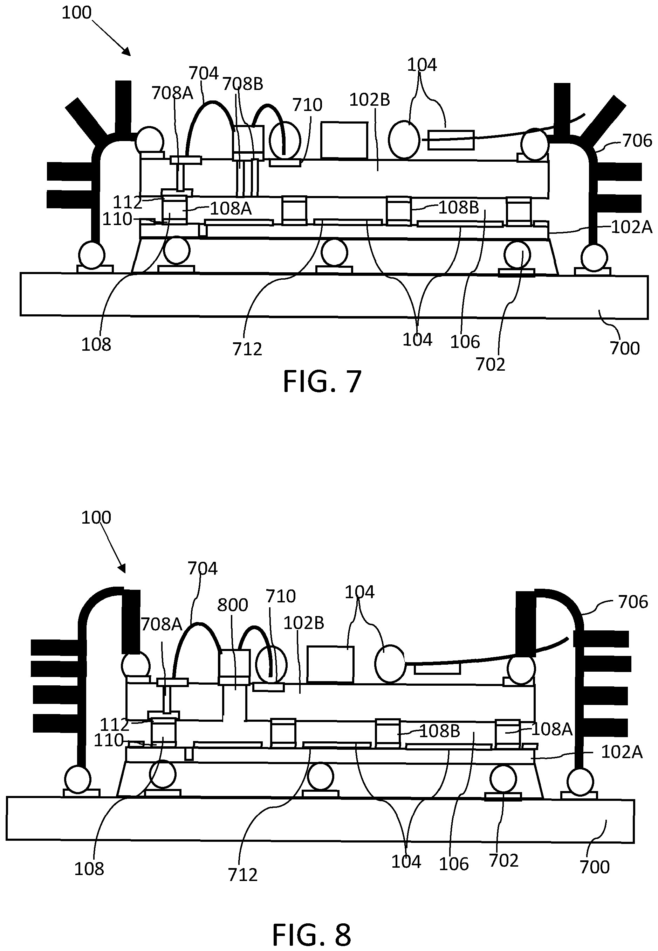

Fig. 7 shows a chip 100 according to some examples of the disclosure. Fig. 7 shows a cross section of the chip 100. Where the chip 100 comprises more than one of the same element, such as a wall 108A, 108B or solder bump 702, only some of the instances of that element are labelled to maintain clarity of the Fig.

The chip 100 is provided on a substrate 700. The substrate can comprise silicon or any other suitable material.

In this example the chip 100 comprises two integrated circuit layers 102A, 102B. The integrated circuit layers 102A, 102B are arranged in a stack. The stacking of the integrated circuit layers 102A, 102B provides a three dimensional chip 100. The second integrated circuit layer 102B is provided overlaying the first integrated circuit layer 102A.

In the example of Fig. 7 the first integrated circuit layer 102A is attached to the substrate 700 via multiple solder bumps 702.

The first integrated circuit layer 102A comprises multiple components 104. The multiple components 104 can be mounted on a surface of a substrate. The substrate of the first integrated circuit layer 102A can comprise silicon, glass, ceramic, or any other suitable material. The substrate can comprise an electrically insulating material. The components 104 can comprise electronic and/or photonic components. Electrical connections can be provided between the components 104 on the first integrated circuit layer 102A. The electrical connections can be provided on the surface of the substrate.

The second integrated circuit layer 102B also comprises multiple components 104. The multiple components 104 can be mounted on a surface of another substrate. The substrate of the second integrated circuit layer 102B can comprise silicon, glass, ceramic, or any other suitable material. The substrate can comprise an electrically insulating material. The components 104 can comprise electronic and/or photonic components. Electrical connections 704 can be provided between the components 104 on the second integrated circuit layer 102B.

A cooling channel 106 is provided between the first integrated circuit layer 102A and the second integrated circuit layer 102B. The side edges of the cooling channel 106 are formed by at least a first wall 108A and a second wall 108B. The walls 108A, 108B can be formed using any of the processes shown in Figs. 2 to 5D. In the example of Fig. 7 the walls 108A, 108B comprise a single portion but walls 108A, 108B comprising multiple portions could be used in other examples. The first integrated circuit layer 102A provides a lower edge for the cooling channel 106 and the second integrated circuit layer 102B provides an upper edge for the cooling channel 106.

The walls 108A, 108B can be arranged to provide a meandering cooling channel 106 as shown in Figs. 6A or 6B or could be arranged in any other suitable configuration. For instance, the walls 108A, 108B could be arranged to provide multiple cooling channels 106 and one or more of the walls 108A, 108B can provide a barrier between adjacent cooling channels 106.

A first edge of the walls 108A, 108B is attached to the first integrated circuit layer 102A. The first edge of the walls 108A, 108B is attached to the first integrated circuit layer 102A by first bonding material 110. A second edge of the walls 108A, 108B is attached to the second integrated circuit layer 102B. The second edge of the walls 108A, 108B is attached to the second integrated circuit layer 102B by second bonding material 112. The second bonding material 112 can be different to the first bonding material 110. The first bonding material 110 and the second bonding material 112 can have different melting points.

In the example of Fig. 7 the chip 100 comprises a heat sink 706. The heat sink 706 can be provided around the edge of the chip 100. The heat sink 706 can comprise means for transferring heat from the chip 100. In some examples the heat sink 706 can be arranged to transfer heat from the cooling fluid that circulates through the cooling channel 106. The heat sink 706 can comprise a heat rejection surface. The heat sink 706 can comprise a thermally conductive material. The heat sink 706 can comprise a metal such as copper or any other suitable material.

The heat sink 706 can be bonded to the substrate 700 by solder bumps 702. The material that is used to bond the heat sink 706 to the substrate 700 can be different to the material the used to bond the first integrated circuit layer 102A to the substrate 700.

In some examples one or more of the integrated circuit layers 102A, 102B can comprise one or more through silicon vias (TSV) 708. In the example of Fig. 7 the TSVs 708 are provided in the second integrated circuit layer 102B and comprise a thermally and/or electrically conductive material. The TSVs 708 can extend right through the substrate.

In the example of Fig. 7 a first TSV 708A is provided from a bonding pad 710, through the substrate to a wall 108A. The wall 108A can comprise an electrically conductive material so that this can provide an electrical connection between components 104 on the second integrated circuit layer 102B and components 104 on the first integrated circuit layer 102A. The TSV 708A and wall 108A can provide a galvanic path between components 104 on the second integrated circuit layer 102B and components 104 on the first integrated circuit layer 102A. This can provide for a shorter electrical connection compared to having the components 104 mounted on the same substrate.

In the example of Fig. 7 a second TSV 708B is provided from a bonding pad 710 underneath a component 104 directly to the cooling channel 106. The TSV 708B can help to transfer heat from the component 104 to the cooling fluid in the cooling channel 106. The second TSV 708B can provide a thermal via. This can improve the efficiency of the heat transfer from the components 104. The thermal via 708B can be provided underneath the components 104 that are the most temperature sensitive.

In some examples the chip 700 can comprise a hydrophilic film 712. The hydrophilic film could be positioned close to components 702 that generated unwanted heat. The hydrophilic film 712 can help with the transfer of heat into the cooling fluid within the cooling channel 106.

In the example of Fig. 7 the chip 100 comprises two integrated circuit layers 102A, 102B. The chip 100 could comprise additional two integrated circuit layers (not shown) in other examples. One or more cooling channels 106 could be provided between each of the pairs of the integrated circuit layers.

Fig. 8 shows another chip 100 according to some examples of the disclosure. The chip 100 shown in Fig. 8 is similar to the chip 100 shown in Fig. 7 and corresponding reference numerals are used for corresponding features.

In Fig. 8 the TSV 800 beneath the component 104 on the second integrated circuit layer 102B is a fluidic via. In this case the fluidic via comprises a discontinuity or gap is provided in the substrate and cooling fluid can flow into the gap. This enables the cooling fluid to come closer to the component which can help to improve heat transfer into the cooling fluid.

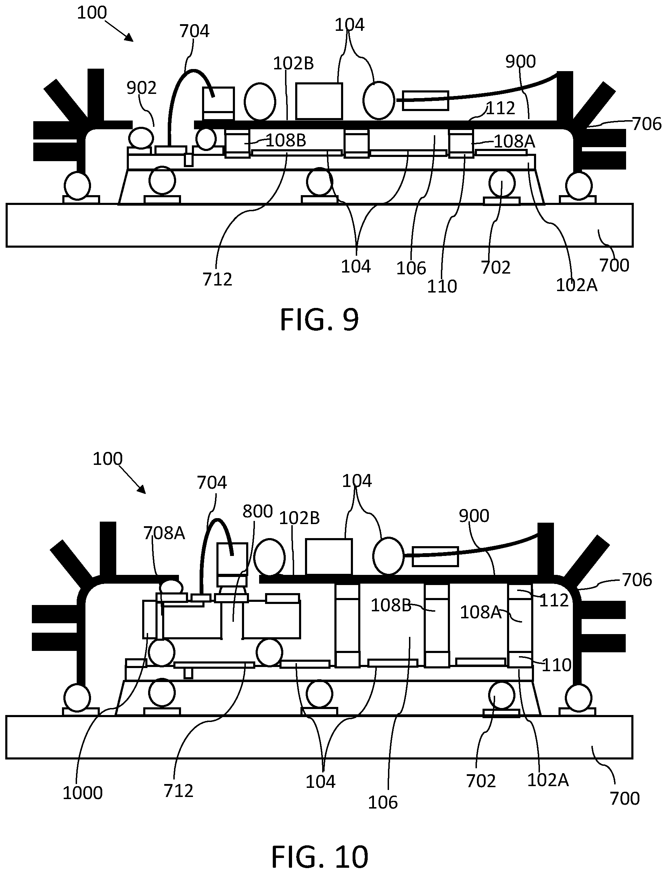

Fig. 9 shows another chip 100 according to some examples of the disclosure. The chip 100 shown in Fig. 9 is similar to the chips 100 shown in Figs. 7 and 8 and corresponding reference numerals are used for corresponding features.

However, in the example of Fig. 9 the heat sink 706 provides the substrate for the second integrated circuit layer 102B. In this case the components 104 of the second integrated circuit layer 102B can be mounted on the heat sink 706. The heat sink 706 can comprise a flat, or substantially flat portion 900. The flat portion 900 is provided overlaying, at least part of the first integrated circuit layer 102A. This arrangement of the heat sink 706 can increase the surface area available for the heat sink 706.

In this case the second edges of the walls 108A, 108B are attached to the flat portion 900 of the heat sink 706. The second edges of the walls 108A, 108B are attached to the flat portion 900 heat sink 706 by second bonding material 112.

In the example of Fig. 9 the flat portion 900 of the heat sink 706 extends across some of the first integrated circuit layer 102A. A gap 902 or discontinuity is provided in the flat portion 902. One or more connections 704 can be provided through the gap 902 to enable components 104 in the second integrated circuit layer 102B to be connected to components 104 in the first integrated circuit layer 102A

Fig. 10 shows another chip 100 according to some examples of the disclosure. The chip 100 shown in Fig. 10 is similar to the chips 100 shown in Figs. 7 to 9 and corresponding reference numerals are used for corresponding features.

In Fig. 10 the heat sink 706 also provides the substrate for the second integrated circuit layer 102B. In this case an interposer 1000 is also provided. The interposer 1000 can provide a substrate for some other components 104. The interposer 1000 can be attached to the first integrated circuit layer 102A by solder bumps 702.

The interposer 1000 can comprise silicon, glass, ceramic, or any other suitable material. A first TSV 708A can be provided through the interposer 1000 to provide an electrical connection between components on the interposer 1000 and components on the first integrated circuit layer 102A.

The interposer 1000 can also comprise a fluidic TSV 800. The fluidic TSV 800 can be positioned beneath a component 104 to improve heat transfer from the component 104.

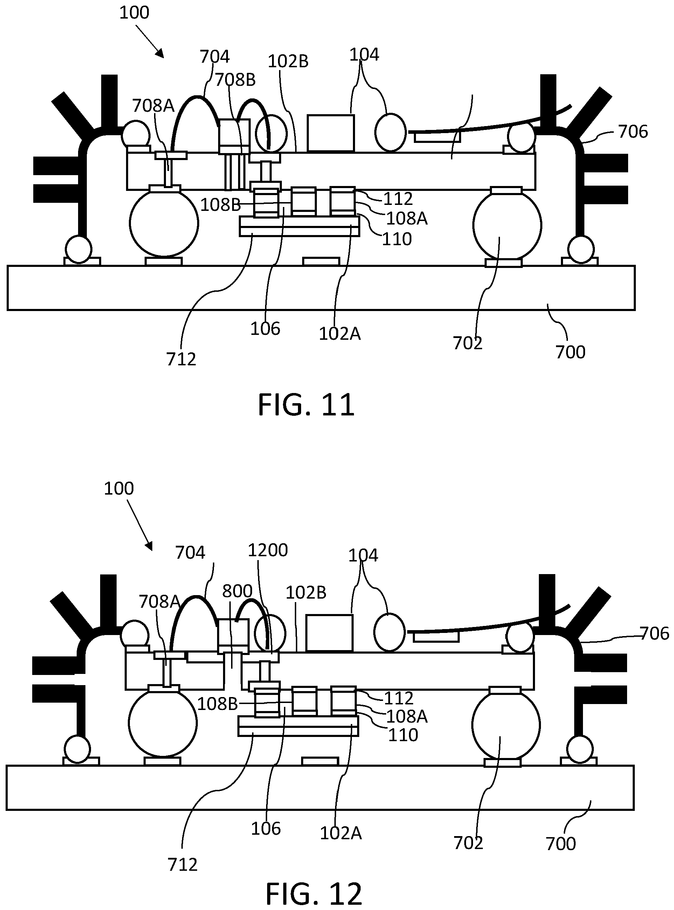

Fig. 11 shows another chip 100 according to some examples of the disclosure. The chip 100 shown in Fig. 11 is similar to the chips 100 shown in Figs. 7 to 10 and corresponding reference numerals are used for corresponding features.

In the example of Fig. 11 the chip 100 comprises a first integrated circuit layer 102A on a first substrate and a second integrated circuit layer 102B on a second substrate. The second integrated circuit layer 102B is provided overlaying the first integrated circuit layer 102A.

The first integrated circuit layer 102A is smaller than the second integrated circuit layer 102B. The first integrated circuit layer 102A can be bonded to the second integrated circuit layer 102B by the walls 108A, 108B that form the cooling channels 106.

In this example the first integrated circuit layer 102A is not directly bonded to the substrate 700. There are no solder bumps attaching the substrate of the first integrated circuit layer 102A is to the substrate 700. In this example the substrate of the second integrated circuit layer 102B also bears the weight of the first integrated circuit layer 102A via the walls 108A, 108B attached to the underside of the substrate.

A solder bump 702 is provided between the substrate of the second integrated circuit layer 102B and the substrate 700 of the chip 100. The solder bump 702 connects the substrate of the second integrated circuit layer 102B and the substrate 700 of the chip 100.

TSVs 708 are provided in the substrate of the second integrated circuit layer 102B. A first TSV 708A can electrically connect one or more components 104 of the second integrated circuit layer 102B to the solder bump 702 that connects the substrate of the second integrated circuit layer 102B and the substrate 700 of the chip 100. This could be used for grounding the components of the second integrated circuit layer 102B or for any other suitable purpose.

A second TSV 708B can electrically connect one or more components 104 of the second integrated circuit layer 102B to a wall that forms the cooling channel 106. This can enable the one or more components 104 of the second integrated circuit layer 102B to be electrically connected to one or more components 104 of the first integrated circuit layer 102A.

Fig. 12 shows a chip according to some examples of the disclosure. The chip 100 shown in Fig. 12 is similar to the chips 100 shown in Figs. 7 to 11 and corresponding reference numerals are used for corresponding features.

In Fig. 12 the TSV 800 beneath the component 104 on the second integrated circuit layer 102B is a fluidic via. In this case the fluidic via comprises a discontinuity or gap is provided in the substrate 1and cooling fluid can flow into the gap. This enables the cooling fluid to come closer to the component 104 which can help to improve heat transfer into the cooling fluid.

In the example of Fig. 12 a bonding interface 1200 is provided in the substrate of the second integrated circuit layer 102B. The bonding interface 1200 can provide the sealing of the channel by holding the component 104 in place.

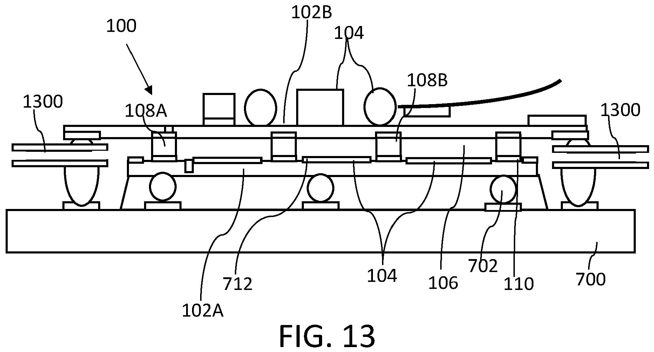

Fig. 13 shows another chip 100 according to some examples of the disclosure. The chip 100 shown in Fig. 13 is similar to the chips 100 shown in Figs. 7 to 12 and corresponding reference numerals are used for corresponding features.

In the example of Fig. 13 the chip 100 comprises a first integrated circuit layer 102A comprising a first substrate and a second integrated circuit layer 102B comprising a second substrate. The second integrated circuit layer 102B is provided overlaying the first integrated circuit layer 102A.

One or more cooling channels 106 formed by walls 108A, 108B are provided between the first integrated circuit layer 102A and the second integrated circuit layer 102B.

In this example the second integrated circuit layer 102B is larger than the first integrated circuit layer 102A so that the substrate of the second integrated circuit layer 102B has a larger footprint than the substrate of the first integrated circuit layer 102A. The edges of the substrate of the second integrated circuit layer 102B extend beyond the edges of the substrate of the first integrated circuit layer 102A.

A solder bump 702 is provided between the substrate of the second integrated circuit layer 102B and the substrate 700 of the chip 100. The solder bump 702 that connects the substrate of the second integrated circuit layer 102B to the substrate 700 of the chip 100 is larger than the solder bump 702 that connects the substrate of the first integrated circuit layer 102A and the substrate 700 of the chip 100. The solder bump 702 that connects the substrate of the second integrated circuit layer 102B and the substrate 700 of the chip 100 can comprise a different material to the solder bump 702 that connects the substrate of the first integrated circuit layer 102A and the substrate 700 of the chip 100.

In this example the chip 100 does not comprise a heat sink 706. Instead a conduit 1300 is provided on each side of the chip. The conduit 1100 can enable cooling fluid to be pumped through the cooling channel 106 and away from the chip 100 to a secondary cooling means.

The conduit 1300 can extend through the solder bump 702 that connects the substrate of the second integrated circuit layer 102B and the substrate 700 of the chip 100.

The conduit 1300 can be formed from a bondable material such as copper or any other suitable material.

The apparatus can be provided in an electronic device, for example, a mobile terminal, according to an example of the present disclosure. It should be understood, however, that a mobile terminal is merely illustrative of an electronic device that would benefit from examples of implementations of the present disclosure and, therefore, should not be taken to limit the scope of the present disclosure to the same. While in certain implementation examples, the apparatus can be provided in a mobile terminal, other types of electronic devices, such as, but not limited to: mobile communication devices, hand portable electronic devices, wearable computing devices, portable digital assistants (PDAs), pagers, mobile computers, desktop computers, televisions, gaming devices, laptop computers, cameras, video recorders, GPS devices and other types of electronic systems, can readily employ examples of the present disclosure. Furthermore, devices can readily employ examples of the present disclosure regardless of their intent to provide mobility.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to 'comprising only one...' or by using 'consisting.'

In this description, the wording 'connect', 'couple' and 'communication' and their derivatives mean operationally connected/coupled/in communication. It should be appreciated that any number or combination of intervening components can exist (including no intervening components), i.e., to provide direct or indirect connection/coupling/communication. Any such intervening components can include hardware and/or software components.

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can', or 'may' refers to a particular instance in a class of examples. A property of the instance can be a property of only that instance or a property of the class or a property of a sub-class of the class that includes some but not all the instances in the class. It is therefore implicitly disclosed that a feature described with reference to one example but not with reference to another example, can where possible be used in that other example as part of a working combination but does not necessarily have to be used in that other example.

As used herein, "at least one of the following: " and "at least one of " and similar wording, where the list of two or more elements are joined by "and" or "or" mean at least any one of the elements, or at least any two or more of the elements, or at least all the elements.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

The description of a feature, such as an apparatus or a component of an apparatus, configured to perform a function, or for performing a function, should additionally be considered to also disclose a method of performing that function. For example, description of an apparatus configured to perform one or more actions, or for performing one or more actions, should additionally be considered to disclose a method of performing those one or more actions with or without the apparatus.

Although features have been described with reference to certain examples, those features may also be present in other examples whether described or not.

The term 'a', 'an' or 'the' is used in this document with an inclusive not an exclusive meaning. That is any reference to X comprising a/an/the Y indicates that X may comprise only one Y or may comprise more than one Y unless the context clearly indicates the contrary. If it is intended to use 'a', 'an' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

As used herein, the terms "the at least one" and "the one or more" mean "any one of the at least one" and "any one of the one or more" respectively.

The presence of a feature (or combination of features) in a claim is a reference to that feature or (combination of features) itself and to features that achieve substantially the same technical effect (equivalent features). The equivalent features include, for example, features that are variants and achieve substantially the same result in substantially the same way. The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description. Nonetheless, the above description should be read as implicitly including reference to such alternative structures and method features which provide equivalent functionality unless such alternative structures or method features are explicitly excluded in the above description of the examples of the present disclosure.

Whilst endeavoring in the foregoing specification to draw attention to those features believed to be of importance the Applicant may seek protection via the claims in respect of any patentable feature or combination of features hereinbefore referred to and/or shown in the drawings whether or not emphasis has been placed thereon.

## Claims

1. A chip comprising:
multiple integrated circuit layers wherein each respective integrated circuit layer comprises one or more electronic and/or photonic components and the multiple integrated circuit layers are arranged in a stack;
a cooling channel positioned between a first integrated circuit layer and a second integrated circuit layer of the multiple integrated circuit layers wherein the cooling channel is bounded by at least a first wall and a second wall and configured to enable a cooling fluid to provide cooling of one or more electronic and/or photonic components on the multiple integrated circuit layers; and
wherein the first wall and the second wall comprise:
a first bonding material arranged on a first edge of the first wall and the second wall, respectively, for bonding the first edge of the first wall and the first edge of the second wall to the first integrated circuit layer; and
a second bonding material arranged on a second edge of the first wall and the second wall, respectively, for bonding the second edge of the first wall and the second edge of the second wall to the second integrated circuit layer.

2. A chip as claimed in claim 1 wherein the first bonding material and the second bonding material have different melting points.

3. A chip as claimed in any preceding claim wherein the first wall and the second wall provide structural support for at least one of the first integrated circuit layer or the second integrated circuit layer.

4. A chip as claimed in any preceding claim wherein the first wall and the second wall provide side edges for the cooling channel, and wherein the first integrated circuit layer and the second integrated circuit layer provide upper and lower edges for the cooling channel.

5. The chip of any one of the preceding claims wherein at least one of the first wall and the second wall provides a barrier between two adjacent cooling channels.

6. A chip as claimed in any preceding claim wherein the first wall and the second wall comprise an electrically conductive material.

7. A chip as claimed in claim 6 wherein the first wall and/or the second wall are configured to enable power and/or electrical signals to be transferred between the first integrated circuit layer and the second integrated circuit layer.

8. A chip as claimed in any preceding claim wherein the heat sink comprises a surface and the surface provides a substrate for at least one of the first integrated circuit layer or the second integrated circuit layer.

9. A chip as claimed in any preceding claim wherein each of the first wall and the second wall comprises a first horizontal portion and a second horizontal portion, wherein the first portion and the second portion are bonded to each other by a third bonding material.

10. A chip as claimed in any preceding claim wherein the cooling channel is one of:
a closed channel; or
an open channel.

11. A chip as claimed in any preceding claim wherein the chip further comprises at least one of:
a hydrophilic film positioned within the cooling channel; or
a hydrophobic film positioned within the cooling channel.

12. A method of forming a chip, the method comprising:
forming at least two walls, including a first wall and a second wall, on a carrier layer, wherein the walls are arranged to provide a cooling channel between the first wall and the second wall;
attaching a first edge of the first wall and a first edge of the second wall to a first integrated circuit layer;
removing the first wall and the second wall from the carrier layer; and
attaching a second edge of the first wall and a second edge of the second wall to a second integrated circuit layer so that the first integrated circuit layer and the second integrated circuit layer are arranged in a stack and the cooling channel is positioned between the first integrated circuit layer and the second integrated circuit layer.

13. The method as claimed in claim 12 wherein forming the first wall and the second wall comprises:
forming pits in the carrier layer;
depositing first bonding material in the pits;
depositing material over the first bonding material to form the first wall and the second wall; and
depositing second bonding material on exposed upper edges of the first wall and the second wall.

14. The method as claimed in claim 12 wherein forming the first wall and the second wall comprises:
providing a releasable layer on the carrier layer;
depositing first bonding material on the releasable layer;
depositing material over the first bonding material to form the first wall and the second wall; and
depositing second bonding material on exposed edges of the first wall and the second wall.

15. The method as claimed in any of claims 12 to 14 wherein the method comprises:
attaching a first portion of the first wall and a first portion of the second wall to the first integrated circuit layer;
providing a second portion of the first wall and a second portion of the second wall on a carrier layer;
bonding the first portion of the first wall to the second portion of the first wall and bonding the first portion of the second wall to the second portion of the second wall;
removing the carrier layer from the second portion of the first wall and from the second portion of the second wall; and
bonding the second portion of the first wall and the second portion of the second wall to a second integrated circuit layer.

## Amended claims

### Amended claims in accordance with Rule 137(2) EPC.

1. A chip (100) comprising:
multiple integrated circuit layers (102A, 102B) wherein each respective integrated circuit layer (102A, 102B) comprises one or more electronic and/or photonic components (104) and the multiple integrated circuit layers (102A, 102B) are arranged in a stack;
a cooling channel (106) positioned between a first integrated circuit layer (102A) and a second integrated circuit layer (102B) of the multiple integrated circuit layers (102A, 102B) wherein the cooling channel (106) is bounded by at least a first wall (108A) and a second wall (108B) and configured to enable a cooling fluid to provide cooling of one or more electronic and/or photonic components (104) on the multiple integrated circuit layers (102A, 102B); and
wherein the first wall (108A) and the second wall (108B) comprise:
a first bonding material (110) arranged on a first edge of the first wall (108A) and the second wall (108B), respectively, for bonding the first edge of the first wall (108A) and the first edge of the second wall (108B) to the first integrated circuit layer (102A); and
a second bonding material (112) arranged on a second edge of the first wall (108A) and the second wall (108B), respectively, for bonding the second edge of the first wall (108A) and the second edge of the second wall (108B) to the second integrated circuit layer (102B).

2. A chip (100) as claimed in claim 1 wherein the first bonding material (110) and the second bonding material (112) have different melting points.

3. A chip (100) as claimed in any preceding claim wherein the first wall (108A) and the second wall (108B) provide structural support for at least one of the first integrated circuit layer (102A) or the second integrated circuit layer (102B).

4. A chip (100) as claimed in any preceding claim wherein the first wall (108A) and the second wall (108B) provide side edges for the cooling channel (106), and wherein the first integrated circuit layer (102A) and the second integrated circuit layer (102B) provide upper and lower edges for the cooling channel (106).

5. The chip (100) of any one of the preceding claims wherein at least one of the first wall (108A) and the second wall (108B) provides a barrier between two adjacent cooling channels (106).

6. A chip (100) as claimed in any preceding claim wherein the first wall (108A) and the second wall (108B) comprise an electrically conductive material.

7. A chip (100) as claimed in claim 6 wherein the first wall (108A) and/or the second wall (108B) are configured to enable power and/or electrical signals to be transferred between the first integrated circuit layer (102A) and the second integrated circuit layer (102B).

8. A chip (100) as claimed in any preceding claim wherein a heat sink (706) comprises a surface and the surface provides a substrate (700) for at least one of the first integrated circuit layer (102A) or the second integrated circuit layer (102B).

9. A chip (100) as claimed in any preceding claim wherein each of the first wall (108A) and the second wall (108B) comprises a first horizontal portion (502) and a second horizontal portion (504), wherein the first portion (502) and the second portion (504) are bonded to each other by a third bonding material (500).

10. A chip (100) as claimed in any preceding claim wherein the cooling channel (106) is one of:
a closed channel; or
an open channel.

11. A chip (100) as claimed in any preceding claim wherein the chip (100) further comprises at least one of:
a hydrophilic film (712) positioned within the cooling channel (106); or
a hydrophobic film positioned within the cooling channel (106).

12. A method of forming a chip (100), the chip (100) as claimed in claim 1, the method comprising:
forming (200) at least two walls (108A, 108B), including a first wall (108A) and a second wall (108B), on a carrier layer (300), wherein the walls (108A, 108B) are arranged to provide a cooling channel (106) between the first wall (108A) and the second wall (108B);
attaching (202) a first edge of the first wall (108A) and a first edge of the second wall (108B) to a first integrated circuit layer (102A);
removing (204) the first wall (108A) and the second wall (108B) from the carrier layer (300); and
attaching (206) a second edge of the first wall (108A) and a second edge of the second wall (108B) to a second integrated circuit layer (102B) so that the first integrated circuit layer (102A) and the second integrated circuit layer (102B) are arranged in a stack and the cooling channel (106) is positioned between the first integrated circuit layer (102A) and the second integrated circuit layer (102B).

13. The method as claimed in claim 12 wherein forming the first wall (108A) and the second wall (108B) comprises:
forming pits (302) in the carrier layer (300);
depositing first bonding material (110) in the pits (302);
depositing material over the first bonding material (110) to form the first wall (110A) and the second wall (110B); and
depositing second bonding material (112) on exposed upper edges of the first wall (108A) and the second wall (108B).

14. The method as claimed in claim 12 wherein forming the first wall (108A) and the second wall (108B) comprises:
providing a releasable layer (400) on the carrier layer (300);
depositing first bonding material (110) on the releasable layer (400);
depositing material over the first bonding material (110) to form the first wall (108A) and the second wall (108B); and
depositing second bonding material (112) on exposed edges of the first wall (108A) and the second wall (108B).

15. The method as claimed in any of claims 12 to 14 wherein the method comprises:
attaching a first portion of the first wall (108A) and a first portion of the second wall (108B) to the first integrated circuit layer (102A);
providing a second portion of the first wall (108A) and a second portion of the second wall (108B) on a carrier layer (300);
bonding the first portion of the first wall (108A) to the second portion of the first wall (108A) and bonding the first portion of the second wall (108B) to the second portion of the second wall (108B);
removing the carrier layer (300) from the second portion of the first wall (108A) and from the second portion of the second wall (108B); and
bonding the second portion of the first wall (108A) and the second portion of the second wall (108B) to a second integrated circuit layer (102B).
